# EUROPEAN PATENT APPLICATION

(11) **EP 1 408 343 A1**
(43) Date of publication of application: **14.04.2004**
(21) Application number: 03003437.5
(22) Date of filing: 14.02.2003
(51) Int. Cl.: G01S 17/02, G01S 7/481, H03K 17/945

(54) **Window for a proximity detector, proximity detector, mobile terminal, and a method for detecting the presence of an object**

(71) Applicant: SIEMENS AKTIENGESELLSCHAFT, 80333 München (DE)
(72) Inventor: Hofmann, Michael, 81671 München (DE); Wipper, Andreas, 81379 München (DE)

(57) **Abstract**

A window (202) to be used in connection with a proximity detector (305) includes an emitter side (E) and a sensor side (S); whereby the emitter side (E) and/or sensor side (S) comprise at least one light directing means (MF1, MF2, MF3, MF4) comprising a structure obtained by tilting or curving at least a part of a bottom surface of the window (202).

## Description

### Field of the invention

The invention relates generally to detecting the presence of an object, and, more specifically, to using infrared radiation in such detection.

### Background of the invention

The rapid growth of mobile communications during the last decade has raised new needs for which mobile terminals are used. A typical example of a new application is the hands-free functionality in which a mobile terminal has different acoustic modes when the device is used in the hands-free mode and like a handset of a conventional telephone, i.e. pressed against the ear of the user.

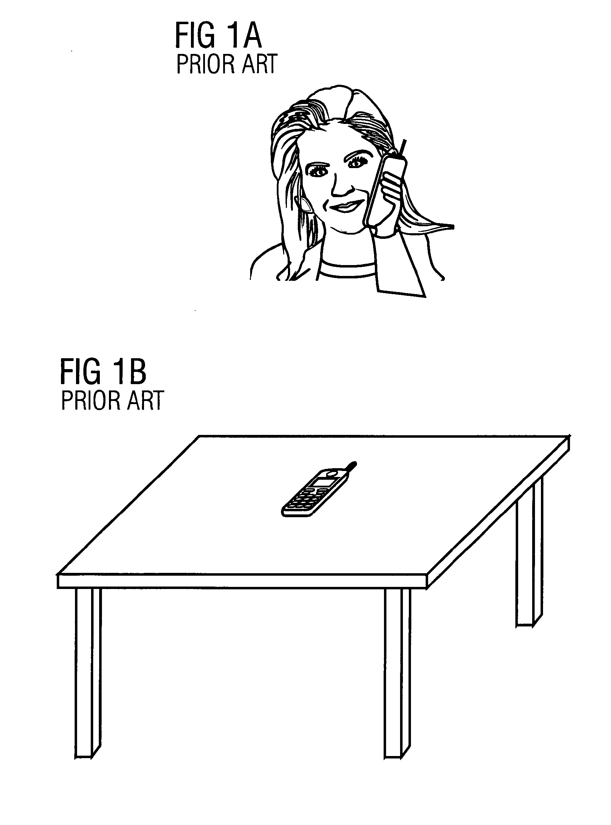

Figure 1A shows a mobile terminal being used as a normal handset.

Figure 1B shows one example of using a mobile terminal in the hands-free mode as a conference phone. The mobile terminal is typically positioned on a table, and participants of the conversation are then seated around the table. In a similar manner, the mobile terminal may be used in a vehicle together with some extra accessories.

Such a hands-free mode sets requirements different from the normal handset mode. First of all, because the user or users are further away from the loudspeaker than in the handset mode, the loudspeaker volume has to be increased.

If the mobile is in hands-free mode the volume is very high. When the user then brings the mobile close to the ear the volume has to be decreased to a low volume to prevent an acoustic shock and a hearing damage. The characteristics of the microphone need not be changed when switching from handset mode to hands-free mode.

These contradictory requirements between the hands-free mode and the normal handset mode have forced many manufacturers to implement a so-called proximity detector into the mobile terminal. The proximity detector is the component which is usually employed to determine in which mode the handset or mobile device should be.

Further, the proximity detector can also be used when the mobile terminal is about to page for an incoming call. The ringing volume will be at full if no object is detected in front of the sensor, but if there is an object in the range of the sensor, the ringing volume will be ramped up.

The purpose of the proximity detector is to detect in which mode the mobile terminal is being used. An example of some structural changes possible is shown in US Patent 6,002,949, where different mechanical solutions for the two acoustical modes are presented.

There are many different ways to perform proximity detection, such as using mechanical switches or using capacitance sensors. One of the most effective solutions has been to use an infrared IR based proximity detector. One secret behind the success has been the small number of changes needed to implement such a proximity detector into an already existing mobile terminal design. Many high-end or middle class mobile terminals already include sending and receiving means for IR communications system, originally intended for close-range data communications. Typical applications are transferring calendar information, memos, or messages such as emails and phonebook entries between the mobile terminal and a computer, or between two mobile terminals.

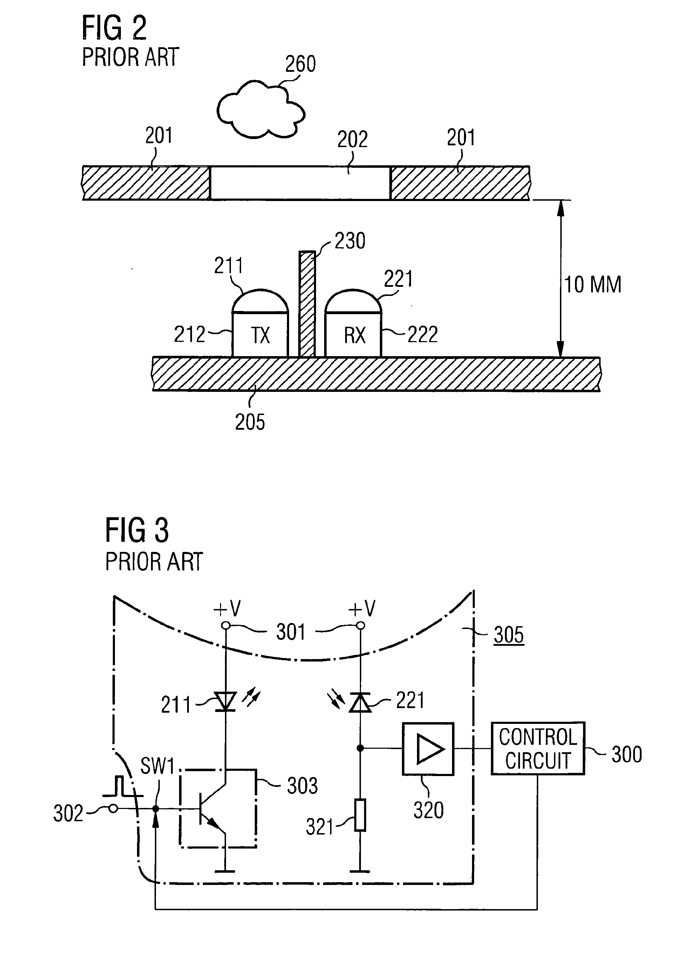

Figure 2 shows a part of a state-of-the-art IR proximity detector. An IR proximity detector usually includes an emitter 211 and a sensor 221 for sending and detecting light in the infrared part of the spectrum. The emitter 211 and sensor 221 are connected to a circuit board 205 with some circuitry 212, 222, respectively, such as diodes or resistors. In the example, however, 211 and 212 is an IR-emitting diode with dome lens, whereas 221 and 222 is only an IR photodiode. Thus the solution may be carried out without using extra resistors or diodes.

The space between the emitter 211 and sensor 221 is shielded using a shield 230 or otherwise arranged in such a manner that the emitter 211 does not emit any IR radiation directly to the sensor 221. Infrared radiation emitted from the emitter 211 is passed outside the housing 201 of the mobile terminal, preferably through a window 202 in the housing 201.

If no IR radiation from the emitter 211 is detected at the sensor 221, it is probable that there is no object 260 causing reflections in the range of the proximity detector. On the contrary, if the object 260, such as the head of the user, is present, if will reflect part of the emitted IR radiation. Some part of the reflected IR radiation passes through the window 202 and is detected at the sensor 221.

Figure 3 shows an example of a prior art proximity detector 305. When the proximity detector 305 is to be used, the Infra-Red emitting diode 211 is turned on by the transistor 303 initiated by the control circuit 300. Control circuit 300 (typically a Central Processing Unit of a mobile terminal) closes switch SW1 to cause current pulse 302 to go through transistor 303. The duration of the pulse 302 may be pretty short, say, from 10 to 200 microseconds. The period is preferably programmable so that the CPU can change the frequency in which the proximity of an object is detected according to the detection history, for example. In this way the proximity detector is adaptive, because there is no need of too frequent proximity detections when the mobile terminal is used only as a handset or only in a hands-free mode.

Part of the IR radiation is detected in the sensor 221. The sensor 221 may be a photo diode which has has a reverse current caused by the IR radiation. This current causes a voltage drop over the resistor and is amplified by the amplifier 320. The amplifier 320 output is directed to control circuit 300 which then gets a proximity response.

If the mobile is in handsfree-mode or an incoming call is detected the proximity sensor tries to detect an object every time. Normally, in addition to this, a proximity detector measures every 1-3 ms whether there is an object in the proximity. Responsive to the hands-free or handset mode command, the mobile station performs the operations necessary, as above described, to change the acoustical and directivity mode of the mobile terminal.

There are still problems with the reliability of the proximity detector. If the reliability is not good enough, the user may experience the volume level of a hands-free mode even when using the mobile terminal as a conventional handset. This not only annoys the user, but may also jeopardize the public safety when the user is, say, driving a car and is suddenly being disturbed by an uncomfortably high voice level.

In order to improve the reliability of the proximity detector, the IR flux to be detected at the sensor 221 has usually been increased in order to generate a stronger sensor output ΔV in the proximity detector, thus needing a larger current for the emitter part 211, 212. Therefore, state-of-the-art proximity detectors consume much more current than physically necessary, which in most mobile terminals is a bad issue, because it significantly shortens the time after which the battery of the mobile terminal has to be recharged and therefore reduces the mobility of the mobile terminal.

The current consumption, though being a bad issue, is not the biggest problem of state-of-the-art proximity detectors. For mobile devices, they are too unreliable and may then give a wrong proximity detection result. This, as described above, can cause hearing damage and also in most less serious cases at least annoy the user of the device.

### Short description of the invention

It is an objective of the invention to bring about a reliable proximity detector and a method for reliably detecting the presence of an object in the proximity of the detector. Another objective of the invention is to use such an apparatus and/or method in a mobile terminal, especially in a mobile or a cordless phone. The objectives of the invention can be achieved as described in any one of the patent claims.

A window, especially to be used in connection with a proximity detector includes an emitter side and a sensor side, any or both of which comprise at least one light directing means comprising a tilted or curved structure on a bottom surface of the window. This decreases cross-talk signal in a proximity detector because disturbing reflections are reduced, so the reliability of the resulting proximity detector will be higher than using a conventional window.

Further, the window may comprise a slit for at least partially separating the emitter side and the sensor side. This helps to further reduce the cross-talk signal. The slit can include assembling means adapted to be assembled onto a wall inside a slit in an outer housing part. An advantage of such a construction is that the assembly of the window to a housing will be easier and faster.

According to one aspect of the present invention, the window can further comprise an inward tilt on a top surface of the window. Advantages of this kind of structure are that the cross-current can further be reduced and that the window will pass a higher proportion of light reflected by a near-field object. Therefore, the resulting proximity detector can also be used in detecting objects very close to the top surface of the window.

According to one further aspect of the present invention, at least one of the light directing means can be a lense-like structure. Further, at least one light directing means is arranged to have a first focal point. By using such a construction higher signal levels are obtained and cross-talk signal can be further reduced.

According to one further aspect of the present invention, the emitter and/or sensor side can comprise at least two light directing means arranged to have at least a first and a second focal point. Then the window can be used in connection with a proximity detector in such a manner that the proximity detector can have at least two detecting points.

A proximity detector comprises i) a window, ii) an optical module comprising an emitter and a sensor, the optical module being adapted to be used as light source and for detecting light, and iii) means for generating a proximity detection signal.

A proximity detector can be arranged to give a detection signal to cross-talk signal ratio over 1.3, and preferably close to 3 or more for a standard grey card (18% reflection) for an object in the first distance range, especially 6 cm from the top surface of the window.

### Brief description of the drawings

This and other objectives of the invention can be achieved with a window, a proximity detector, a method for detecting the presence of an object, and a mobile terminal according to any one of the independent patent claims.

In the following, the invention and its preferred embodiments are described more closely referring to the examples shown in Figures 4 to 11 in the appended drawings, wherein:
- Figure 1A: shows a mobile terminal being used as a handset;
- Figure 1B: shows a mobile terminal being used in the hands-free mode;
- Figure 2: shows a state-of-the-art structure of a proximity detector of a mobile terminal;
- Figure 3: shows the circuitry used in a mobile terminal to command the acoustic modes as a response to proximity detection results obtained from a proximity detector 305;
- Figure 4: shows a system set-up for performing measurements;
- Figure 5: illustrates a problem relating to prior art IR proximity detectors detected while solving the problem;
- Figures 6A, 6B, 6D, and 6E: present advantageous forms for the window 202 according to some embodiments of the invention;
- Figures 7A-7E: illustrate further possible forms for the window 202;
- Figure 8: shows cross-cuts in two dimensions for more window 202 structures;
- Figure 9A: illustrates the manner in which the cross cuts of Figure 8 relate to the actual shape of the window 202;
- Figure 9B: illustrates how the window 202 can be efficiently assembled in a housing of a device;
- Figure 10: shows some measurements results for window shapes of Figure 8; and
- Figure 11: shows a proximity detector 305 according to one aspect of the present invention.

Like reference signs refer to corresponding parts and elements throughout Figures 1-11.

### Detailed description of the invention

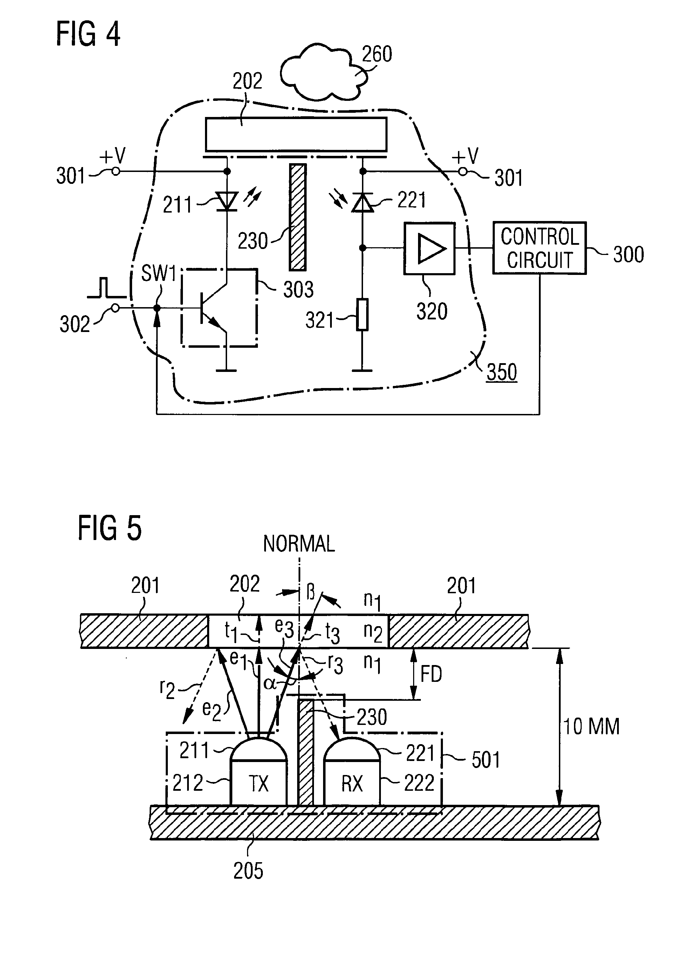

Figure 4 shows how the proximity detector 305 of Figure 3 is adapted to perform proximity detection.
Now the proximity detector 305 includes also a window 202 and a shield 230 adapted to hinder light emitted from emitter 211 to directly propagate to sensor 221.

When object 260 comes to the proximity of window 202, a part of IR light radiated by emitter 211 will be reflected from the surface of the object 260. Sensor 221 will then detect part of the reflected light flux as described with reference to Figure 3, so that there will now be a positive proximity detection response to the control circuit. Typically, the proximity detection response is a voltage signal only.

For a relatively short current pulse (I_{PULSE} = 200 mA), it was observed that when no object was present, the output voltage obtained was V = 640 mV. When object 260 was at 6 cm distance, an output voltage V = 870 mV was obtained. An object made of white material was used as the object 260. The current and the voltages are not fixed and the variation is very large. These voltages are to be understood only as examples to show the reduced crosstalk.

Even though the measurement set-up slightly differs from the proximity detector used in a mobile terminal, it sheds light to the problem at hand which is discussed more in detail with reference to Figure 5.

Figure 5 shows a simplified typical proximity detector of Figure 2. The circuit board 205 is from some distance from the housing 201. Optical module 501 includes the electronics of the proximity detector 305, including the shield 230. The optical module 501 is assembled so that there is a free distance FD between the tallest part of the optical module 501 and the housing 201 and window 202.

Now the emitter 211 is emitting light in the Infrared spectrum. Some of the incident light rays are drawn in Figure 5 and denoted with solid lines e₁, e₂, and e₃. Basically, the emission takes place to a hemisphere (Ω=2π) or to a smaller spatial angle defined by the shape of the emitter 211.

Some of the light rays pass through the window 202. Such light ray has been labeled with t₁ and marked with a dashed line. Some other light rays are reflected from the window 202, and they are marked with r₁ and r₃ and drawn with a dashed line. According to laws of Physics, some reflection occurs always when light is passed from one transport medium to another so that the sum of squares of the transmission coefficient c_{T} and reflection coefficient c_{R} equals one (c_{T}² + c_{R}² = 1). Then, depending on the optical density of the window 202, some light may be absorbed therein, thus decreasing the intensity of the IR radiation.

For light, the Snell's law *n*_{*1*} sin α = *n*_{*2*} sin β defines the angle β in which a light ray the angle of incidence of which is α as defined from the normal of a surface passes on the other side of the interface, where the refractive indices *n*_{*1*} and *n*_{*2*} of the transport media are different on both sides of the interface.

Especially for mobile terminals the situation gets more tricky, because the outer surface of the window 202 is usually dirty. There may be some dirt or grease from the user's fingers etc., creating a further layer on top of the window 202. The new layer caused by the impurities has then a different refractive index, and this layer may cause dispersion and other nasty optical phenomena.

One part of the IR radiation is directly reflected back to the sensor 221. This reflection takes place at any one of the interfaces, say between the inside of the proximity detector 305 and the window 202, between the window 202 and the air outside, and between the window 202 and a possible impurity layer. These reflections cause so-called cross-talk for the proximity detector 305.

Some of the cross-talk can be reduced if the emitter 211 and sensor 221 are located spatially further away from each other. Further, the cross-talk would be reduced even more if the shield 230 were extended to go through the window 202. However, these solutions pose significant problems. First of all, if the window consists of two separate parts, it causes problems with the sealing of the proximity detector 305, and, thus, deteriorates some characteristics of a mobile terminal wherein the proximity detector is used. For example, some mobile terminals need to be water-proof. Evidently, this property is endangered if there are more junctions in the housing.

Secondly, the manufacturing would be more complex. Thirdly, the still continuing miniaturization of the mobile terminals makes larger spatial distances problematic, therefore increasing the power consumption of the proximity detector 305.

In order to reduce the cross-talk, different shapes for the window 202 were investigated. These shapes illustrate different modes for carrying out a part of the present invention.

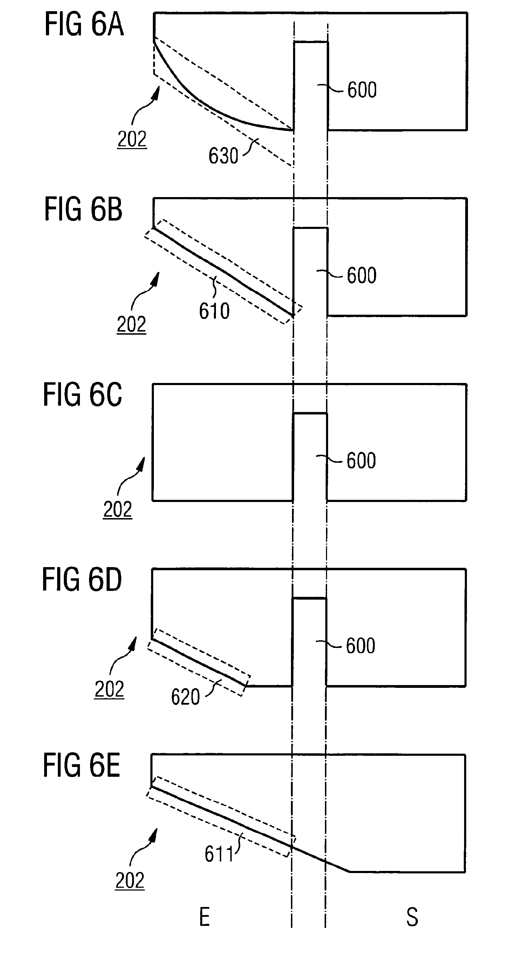

Figures 6A-6E show some examples of cross-sections of advantageous window shapes. Figure 6C is the simpliest of shapes investigated. It includes slit 600 between the emitter side E and sensor side S. The shield 230 may but need not penetrate into the slit 600. Cross-talk voltage V = 80 mV, and in the presence of a (white) object 260 at 6 cm distance, a voltage V = 250 mV was obtained. So even though the coupling of disturbing reflections causing a high cross-talk signal was reduced, this kind of a window structure is not satisfactory.

Figures 6B and 6D show a structure including slit 600 between the emitter side E and sensor side S, but in addition, also a tilted part 610, 620 at the emitter side E. The tilted part 610 may extend wholly up to the slit 600, or only partially as the tilted part 620 does. The tilting apparently reduces reflections causing cross-talk.

Figure 6E shows a window 202 structure without slit 600 but with only tilting 611. Using such a structure, for cross-talk a voltage 100 mV, and for the test object, a voltage 310 mV were obtained.

For the sensor side S a similar tilting as described in Figure 6E can be made. Then the window 202 would include tiltings at both sensor and emitter sides E and S, respectively. For such a construction, cross-talk voltage 100 mV and test object voltage 220 mV were obtained.

The emitter side can be made also round as shown in cross-section 630 of Figure 6A. This kind of window 202 structure provides good properties as well.

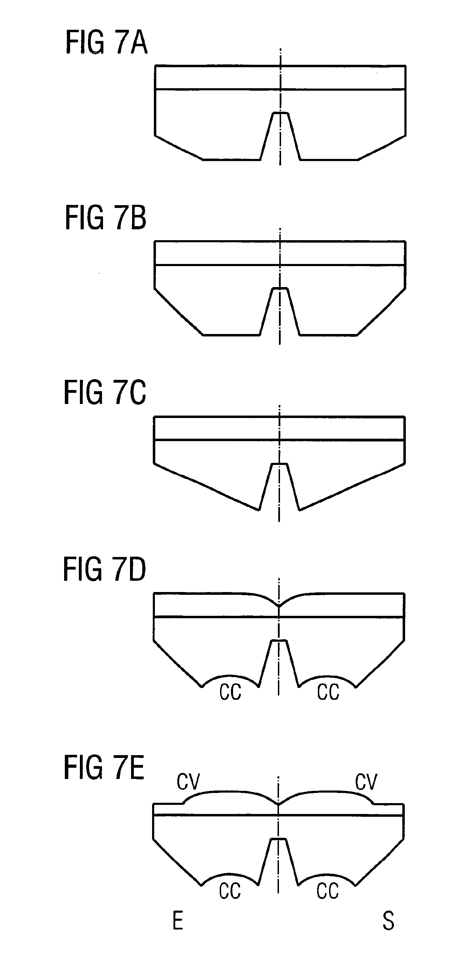

Figures 7A to 7E show other possible shapes for the cross-section of the window 202. The emitter side E and sensor side S can be made to show symmetric forms, and tiltings or even curvatures, or any combinations of these. The tilting or curvature can be designed to give a concave CC or convex CV shapes for the cross-section of the window. Good results have also been obtained by using lense-like structures. If a lense-like structure is used, any or all of the light directing means can be arranged to have one or more focal points.

The material of which the window 202 is made can be selected according to the purposes. "Makrolon" from Bayer plastic or "Lexan" from GE-plastic can be used, for example, as suitable materials. These are largely available polycarbonate products.

Further, by designing the window 202 in the manner described above, a good proximity detector 305 can be constructed. A window 202, according to some aspects of the invention, can be molded as one piece. Therefore the manufacturing cost can be reduced and the assembly is of reduced complexity.

According to one aspect of the the invention, the window 202 comprises at least one light directing means. The light directing means can be selected from a variety of optical solutions. As already shown in connection with the simplest window 202 shapes and structures, the light directing means can be as simple as a material the optical length of which changes causing bending of the light. The optical length can be changed by using different tiltings and/or curvatures. However, as will be illustrated below, the invention is not limited to these simple shapes, but the light directing means may also comprise focusing means as well. An example of focusing means known as such from optical theory is a lense. Some possible shapes have already been discussed in Figures 7D and 7E.

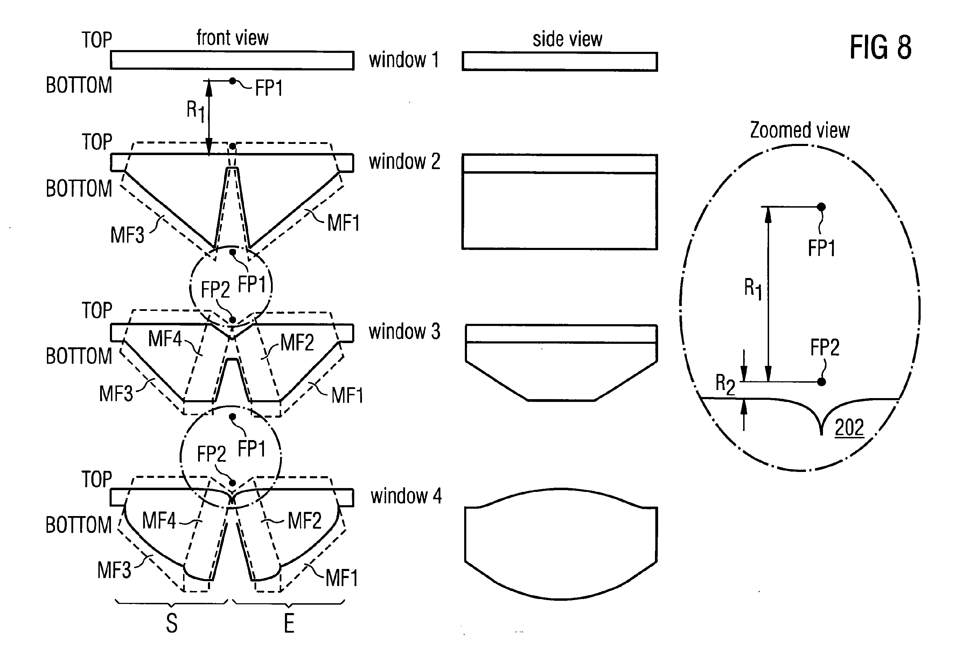

Figure 8 shows some more advanced structures for the window 202.

Window 1 is the conventional window 202 which, as already described, is flat. It has top surface and bottom surface.

Window 2 is a window 202 according to the first aspect of the present invention. It has two tilted sides. The tilted side of the emitter side E is the first light directing means MF1 and causes light passed through bottom surface of the emitter side to get a bit more deflected to the distance range R1 which is located around six centimeters from the top surface of the window 202. The window 202 is symmetric, so that the sensor side S comprises second light directing means MF3.

Window 3 is a more advanced window 202, according to another aspect of the present invention. This window 202 has on the emitter side tiltings as well. These tilted surfaces on the bottom and top form first and third light directing means MF1, MF2.

The first light directing means MF1 cause light passed through the bottom surface of the emitter side E to strongly propagate to distance range R1 which is located around six centimeters from the top surface of the window 202. Likewise for the window 2 any reflection on that distance is, due to the symmetry of the window between the emitter side E and sensor side S, without strong attenuation passed into the second light directing means MF3 and further through the bottom of the sensor side S. This can be understood to be a sort of deflection, though a relative simple one.

Further, the third light directing means MF2 cause light passed through the bottom surface of the emitter side E to strongly propagate to distance range R2 which is located somewhere close to the inward tilt of the top of the window. Preferably, R2 is a range from zero to a few millimeters of the top surface of the window 202. Any reflection on that distance is again, due to the symmetry of the window between the emitter side E and sensor side S, without strong attenuation passed into the fourth light directing means MF4 and further through the bottom of the sensor side S.

Window 4 is an even more advanced window 202, according to a further aspect of the present invention. Window 4 is very similar to window 3, but the surfaces are slightly curved as well. This causes the light to focus on more to the first and second focal point FP1, FP2. Window 4 is then even more a lense-like structure, even though the other windows 2, 3 can be understood to have a first focal point FP1 (windows 2 and 3) and a second focal point FP2 (window 3).

The zoomed view shows better the location of the focal points FP1 and FP2 in relation to the top surface of the window 202.

The side views of the windows 1 to 4 are shown as well. The conventional window 202 (i.e. window 1) did not include any form. According to the present invention, the side view of the window can be flat as well. However, according to further aspects of the present invention, the window 202 can include tiltings (window 3) also in the bottom of the side view, or even a curved structure not only in bottom but on top as well (window 4). It is to be noted that the side view/front view cross cuts of window 202 may vary showing different curvature and/or tiltings along the window. This enhances the lense-like characteristics of the window 202.

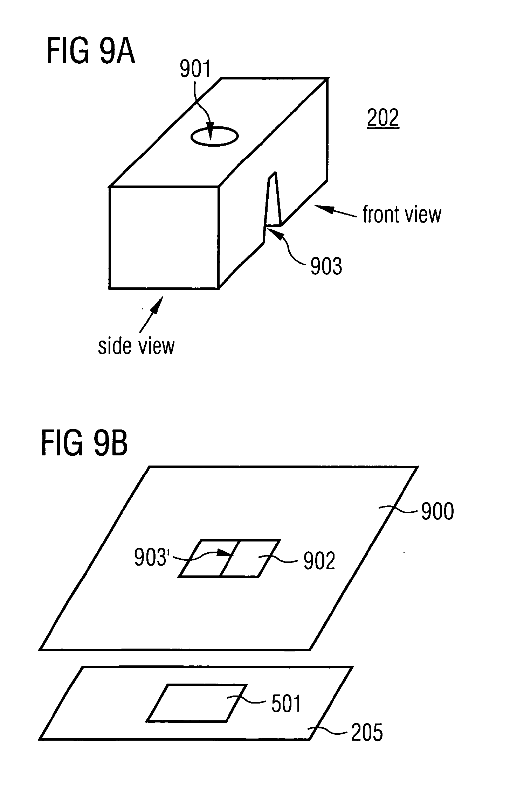

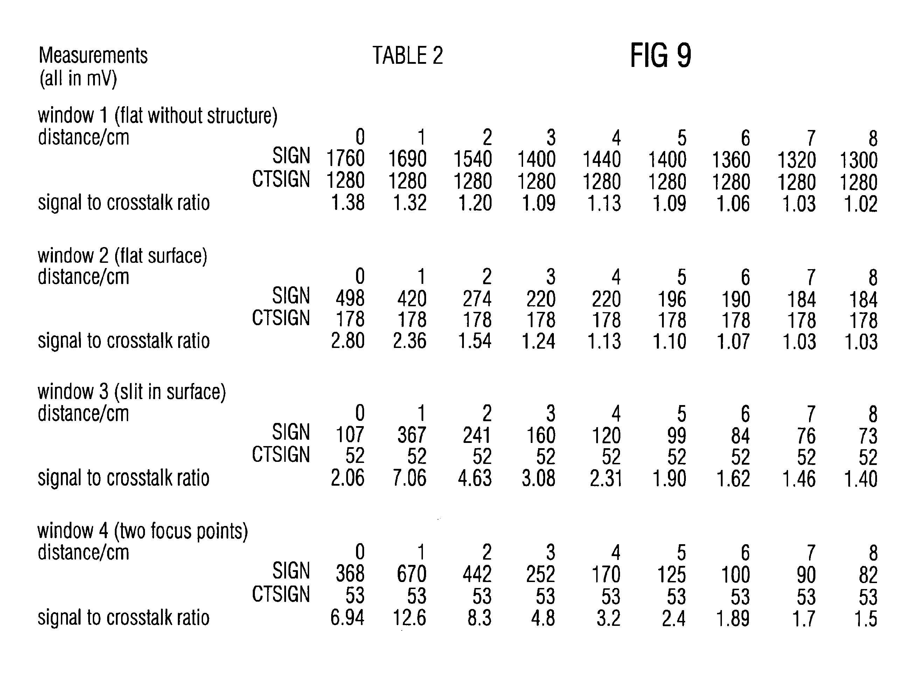

Figure 9A shows how the directions for "side view" and "front view" were defined for windows 1 to 4 in Figure 8. The perspective view shows also the inward tilted part 901 and an assembly slit 903.

Figure 9B shows the meaning of the assembly slit 903 shown in Figure 9A. The assembly slit 903 is placed onto a wall 903' inside a slit 902 corresponding a window hole of an outer housing part 900 of a device. The outer housing part 900 is part of the housing 201 of the device, such as the plastic cover of a mobile phone. The outer housing part 900 is especially the user-side of the housing 201, i.e. the side which the user normally raises on his ear when making or receiving a phone call.

The idea of the wall 903' and the corresponding assembly slit 903 is to make the final assembly faster and less complex. The optical module 501 can similarly be put onto the circuit board 205. By designing the mobile phone, the actual window shape may then slightly depend on the distance of the optical module 501 from the slit 902.

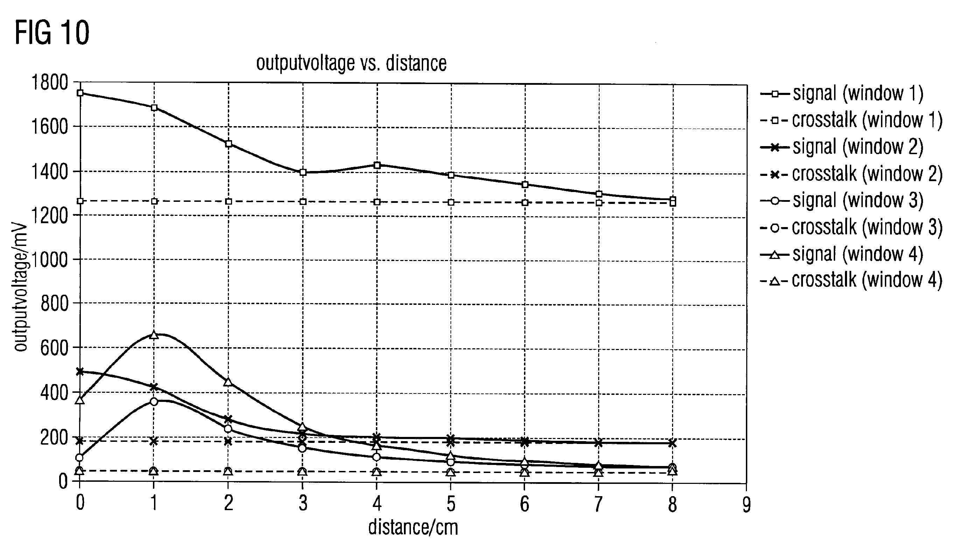

Some measurements for evaluating the performance of windows 1 to 4 were performed as well. The measurements were conducted using a Kodak grey card giving a 18% reflection, and by varying the distance of the grey card from the top surface of the window. The results are listed in Table 1 and further shown in Figure 10.

**Table 1:**

| signal to cross-talk ratio | | | | | |
|---|---|---|---|---|---|
| Distance (cm) | 0 | 1 | 5 | 6 | 7 |
| Window 1 | 1,38 | 1,32 | 1,09 | 1,06 | 1,03 |
| Window 2 | 2,80 | 2,36 | 1,10 | 1,07 | 1,03 |
| Window 3 | 2, 06 | 7, 06 | 1,90 | 1, 62 | 1,46 |
| Window 4 | 6,94 | 12, 64 | 2,36 | 1,89 | 1,70 |

As can be seen from the values in Table 1, the window structures according to the different embodiments of the present invention produce surprisingly good results.

First of all, the signal to cross-talk ratio at the distance range R1 (5 to 7 cm) is better for all window structures 2 to 4. The values for window 4 are significantly much better, this helping in the correct detection of an object in the proximity of the proximity detector 305.

Further, some embodiments of the present invention then enable the use of a proximity detector for detecting whether or not the window 202 of the proximity detector 305 is covered. This has been especially difficult earlier, because even though the output voltage to cross-talk ratio has been relatively good, the problem has been the too high cross-talk signal. This can be seen from annexed Table 2 showing actual measurement results.

The cross-talk signal, as already discussed, is always present when the proximity detector 305 is in use. Its magnitude can be measured when there is no object 260 in the measurement direction of the proximity direction.

Because of the high cross-talk current, it has been a problem especially in state-of-the-art mobile devices that the proximity detector used for changing the acoustic mode does not work if the mobile device is covered. Further, some manufacturers of protective carrying bags do not observe the position of the proximity detector. So using a non-original protective carrying bag may result in hearing damage. The present invention alleviates this problem in a compact manner so that the mode of the mobile device can be changed if the proximity detector 305 detects that the window 202 is covered.

Especially windows 3 and 4 produce very good results. According to one aspect of the invention, the top surface of a window 202 can then include an inward tilted part 901.

The reliability of the device wherein a proximity detector 305 according to some aspects of the present invention are used can be further enhaced in the following way: The strength cross-talk signal current mainly caused by the window is measured every time when the device is entering a mode possibly involving high loudspeaker volume levels. If the measurement result shows that the cross-talk current either is too low or too high as compared to corresponding predefined lower and upper limits, it may be the consequence of the fact that the proximity detector is not working properly. Then such a mode cannot be activated, i.e. high loudspeaker volume cannot be enabled at least without a prior confirmation obtained from the user. Such modes include hands-free mode, using the handset as a gaming device, and using the ringer for paging, for some examples. In other words, this is a fail-safe function and it is used to check that the optical and electrical circuits are working.

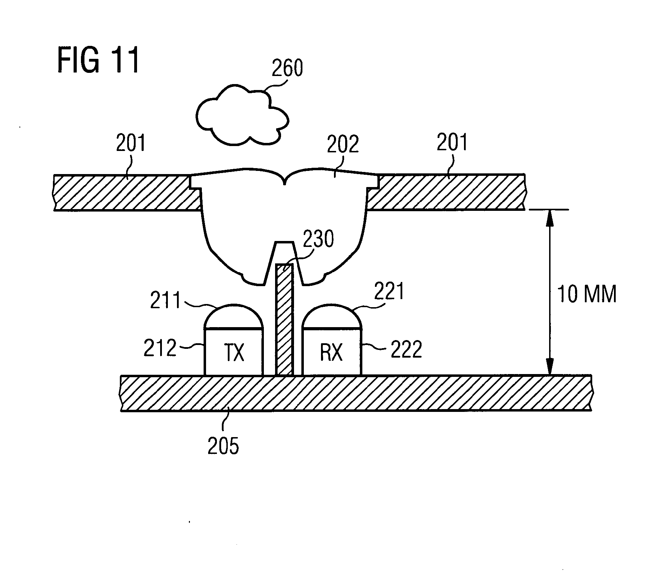

Figure 11 shows a proximity detector 305 according to one aspect of the present invention. Now the window 202 reduces cross-talk signal and the reliability of the proximity detector 305 is enhanced. Further, the selected window 202 shape enables the reliable detection of objects in two detection ranges, around 5 to 7 cm and very close to or on the top surface of the window 202.

Although the invention was described above with reference to the examples shown in the appended drawings, it is obvious that the invention is not limited to these but may be modified by those skilled in the art without difference from the scope and the spirit of the invention.

### List of used references

- 201: housing
- 202: window
- 205: circuit board
- 211: emitter
- 212: emitter circuitry
- 221: sensor
- 222: sensor circuitry
- 230: shield
- 260: object
- 300: control circuit
- 301: voltage source
- 302: current pulse
- 303: transistor
- 305: proximity detector
- 320: amplifier
- 321: resistor
- 401: current source
- 403: voltage source
- 501: optical module
- 600: slit
- 610: tilted part
- 611: tilted part
- 620: partially tilted part
- 630: curved part
- 900: outer housing part
- 901: inward tilted part
- 902: window hole
- 903: slit
- 903': wall

## Claims

1. A window (202) to be used in connection with a proximity detector (305),
**characterized in that**:
the window (202) comprises an emitter side (E) and a sensor side (S) including at least one light directing means (MF1, MF2, MF3, MF4) comprising a tilted or curved structure on a bottom surface of the window (202).

2. A window (202) according to claim 1, **further comprising:**
a slit (600) for at least partially separating the emitter side (E) and the sensor side (S).

3. A window (202) according to claim 2, **wherein:** the slit (600) includes assembling means (903) adapted to be assembled onto a wall inside a slit in an outer housing part (900).

4. A window (202) according to claim 1, 2, or 3, further **comprising:** an inward tilt on a top surface of the window (202).

5. A window (202) according to any one of the preceding claims, **wherein:** at least one of the light directing means (MF1, MF2, MF3, MF4) is a lense-like structure.

6. A window (202) according to claim 5, **wherein:** at least one light directing means (MF1, MF2, MF3, MF4) is arranged to have a first focal point (FP1, FP2)

7. A window (202) according to claim 5 or 6, **wherein:** the emitter (E) and/or sensor side (S) comprise at least two light directing means (MF1, MF2, MF3, MF4) arranged to have at least a first and a second focal point (FP1, FP2).

8. A window (202) according to claim 6 or 7, **wherein:** a distance range (R1) for the first focal point (FP1) is around 6 cm, especially from 5 to 7 cm from a top surface of the window (202).

9. A window according to any one of claims 7, **wherein:** a second distance range (R2) for a second focal point (FP2) is around zero to a few millimeters from top surface of the window (202).

10. A window (202) according to any one of claims 4 to 9,
**characterized in that**:
the window (202) includes
- first light directing means (MF1) 'adapted to focus light through bottom of the emitter side (E) to a first distance range (R1); and
- second light directing means (MF3) adapted to focus a reflection from an object (260), especially the head of a user, in the first distance range (R1), to pass through bottom of the sensor side (S) of the window (202).

11. A window (202) according to claim 10, **further comprising:**
- third light directing means (MF2) adapted to focus light through bottom of the emitter side (E) to a second distance range (R2); and
- fourth light directing means (MF4) adapted to focus a reflection from an object (260), especially any object covering the window (202), in the second distance range (R2), to pass through bottom of the sensor side (S) of the window (202).

12. A window (202) according to any one of the preceding claims 1 to 11, **wherein:** the sensor side (S) is made to mirror symmetric to the emitter side (E), the symmetry axis being between the sensor side (S) and the emitter side (E).

13. A window (202) according to any one of claims 1 to 11, **wherein:** the sensor side (S) is made asymmetric to the emitter side (E).

14. A window (202) according to any one of claims 1 to 13, **wherein:** the window is constructed of plastic, especially of polyacrylamide.

15. A proximity detector (305) **comprising:**
- a window (202) according to any one of the preceding claims 1 to 14;
- an optical module (501) comprising an emitter (211) and a sensor (222), the optical module (501) adapted to be used as light source and for detecting light; and
- means (212, 222) for generating a proximity detection signal.

16. A proximity detector (305) according to claim 15, **wherein:**
- first light directing means (MF1) of the window (202) are adapted to focus light emitted from the emitter (211) and passed through bottom of the emitter side (E) of the window (202), to a distance range (R1); and
- second light directing means (MF3) of the window (202) are adapted to focus light of a reflection from an object (260), especially from the head of a user, in a first distance range (R1), especially around 6 cm, to pass through the bottom of sensor side (S) of the window (202) and further to the sensor (222).

17. A proximity detector (305) according to claim 15 or 16, **wherein:**
- third light directing means (MF2) of the window (202) are adapted to focus light emitted from the emitter (211) and passed through bottom of the emitter side (E) of the window (202), to a distance range (R2); and
- fourth light directing means (MF4) of the window (202) are adapted to focus light of a reflection from an range object (260), the object (260) especially covering the window (202), to pass through the bottom of sensor side (S) of the window (202) and further to the sensor (221).

18. A proximity detector (305) according to any one of claims 15 to 17,
**characterized in that**:
the proximity detector is arranged to give a detection signal (SIGN) to cross-talk signal (CTSIGN) ratio over 1.3, preferably close to 3 or more for a standard grey card for an object (260) in the first distance range (R1), especially 6 cm from the top surface of the window.

19. A mobile device, especially a mobile phone, **comprising:**
- a proximity detector (305) according to any one of claims 15 to 18; and
- a control circuit (300), responsive to the proximity response (PR), for instructing the mobile device to: i) change between a handset mode and a hands-free mode; ii) switch off hands-free mode; and/or iii) ramp a sound ringer of the mobile device.

20. A mobile device according to claim 19, **wherein**: the optical module (501) is mounted onto a circuit board (205) of the mobile device.

21. A mobile device according to claim 19 or 20, **wherein:** the window (302) is mounted on a wall inside a slit in an outer housing part (900) of the mobile device.

22. A mobile device according to claim 21, **wherein:** the window (302) and the optical module (501) are mounted in such a manner that there is a free distance (FD) between the window (302) and the optical module (501).
